# DEMANDE DE BREVET EUROPEEN

(11) **EP 4 481 739 A1**
(43) Date de publication de la demande: **25.12.2024**
(21) Numéro de dépôt: 24183860.6
(22) Date de dépôt: 21.06.2024
(51) Int. Cl.: G10L 25/09

(54) **COMPTEUR D'IMPULSIONS**

(30) Priorité: 22.06.2023 FR 2306509
(71) Demandeur: Dolphin Design, 38240 Meylan (FR)
(72) Inventeur: ESSEY, Konan Constant, 38240 MEYLAN (FR); TRICAUD, Gaspard, 38240 MEYLAN (FR)
(74) Mandataire: Cabinet Beaumont

(57) **Abrégé**

La présente description concerne un compteur d'impulsions (200) comprenant un compteur asynchrone (201) et un circuit (205) configuré pour déclencher une opération de lecture de la valeur dudit compteur asynchrone, ledit circuit (205) étant synchronisé par un signal d'horloge.

## Description

### Domaine technique

La présente description concerne de façon générale les circuits et dispositifs électroniques utilisés dans le domaine du traitement de fichier audio. La présente description se rapporte plus particulièrement à un circuit permettant de compter des impulsions d'un signal obtenu à partir d'un fichier audio.

### Technique antérieure

Le traitement de fichier audio, et en particulier le traitement de fichier audio représentant de la voix humaine, est un enjeu important dans de nombreux domaines scientifiques.

Il serait souhaitable de pouvoir améliorer, au moins en partie, certains aspects des circuits et dispositifs utilisés dans le domaine du traitement de fichier audio, et, en particulier, certains aspects des circuits permettant de compter des impulsions d'un signal obtenu à partir d'un fichier audio.

### Résumé de l'invention

Il existe un besoin pour des circuits et dispositifs utilisés dans le domaine du traitement de fichiers audios, plus performants.

Il existe un besoin pour des circuits et dispositifs utilisés dans le domaine du traitement de fichier audio et fonctionnant à basse fréquence.

Il existe un besoin pour des circuits plus performants permettant de compter des impulsions d'un signal obtenu à partir d'un fichier audio.

Il existe un besoin pour des circuits permettant de compter des impulsions d'un signal obtenu à partir d'un fichier audio et fonctionnant à base fréquence.

Un mode de réalisation pallie tout ou partie des inconvénients des circuits et dispositifs connus utilisés dans le domaine du traitement de fichier audio.

Un mode de réalisation pallie tout ou partie des inconvénients des circuits connus permettant de compter des impulsions d'un signal obtenu à partir d'un fichier audio.

Un mode de réalisation prévoit un compteur d'impulsions comprenant un compteur asynchrone et un circuit configuré pour déclencher une opération de lecture de la valeur dudit compteur asynchrone, ledit circuit étant synchronisé par un signal d'horloge.

Selon un mode de réalisation, le compteur comprend, en outre, une bascule adaptée à recevoir ladite valeur dudit compteur asynchrone pendant une phase de lecture.

Selon un mode de réalisation, une phase de lecture est déclenchée par un front d'un premier signal de synchronisation.

Selon un mode de réalisation, une phase de lecture est arrêtée par un front d'un deuxième signal de synchronisation.

Selon un mode de réalisation, ledit front du deuxième signal de synchronisation déclenche, en outre, la réinitialisation de ladite valeur dudit compteur asynchrone.

Un autre mode de réalisation prévoit un circuit adapté à la reconnaissance de mots à partir d'un fichier audio comprenant un compteur d'impulsions décrit précédemment.

Selon un mode de réalisation, le circuit a une fréquence d'horloge comprise entre 30 et 40 kHz.

Selon un mode de réalisation, la fréquence d'horloge est égale à 32,728 kHz.

Selon un mode de réalisation, le circuit comprend, en outre, un premier circuit adapté à mettre en oeuvre une fonction d'extraction d'une caractéristique acoustique.

Selon un mode de réalisation, le circuit comprend, en outre, un deuxième circuit adapté à intégrer un signal fourni par le premier circuit.

Selon un mode de réalisation, le circuit comprend, en outre, un troisième circuit configuré pour mettre en oeuvre un traitement numérique d'un signal fourni par ledit compteur d'impulsions.

Un autre mode de réalisation prévoit un dispositif adapté à traiter un fichier audio comprenant un circuit décrit précédemment.

Selon un mode de réalisation, le dispositif comprend, en outre, un microphone.

Selon un mode de réalisation, le dispositif comprend, en outre, un réseau de neurones.

Selon un mode de réalisation, le dispositif est adapté à détecter la voix humaine.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, très schématiquement et sous forme de blocs, un mode de réalisation d'un dispositif de traitement d'un fichier audio ;

la figure 2 représente un schéma électrique d'un mode de réalisation d'un compteur d'impulsions du mode de réalisation de la figure 1 ; et

la figure 3 représente des chronogrammes illustrant le fonctionnement du mode de réalisation de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

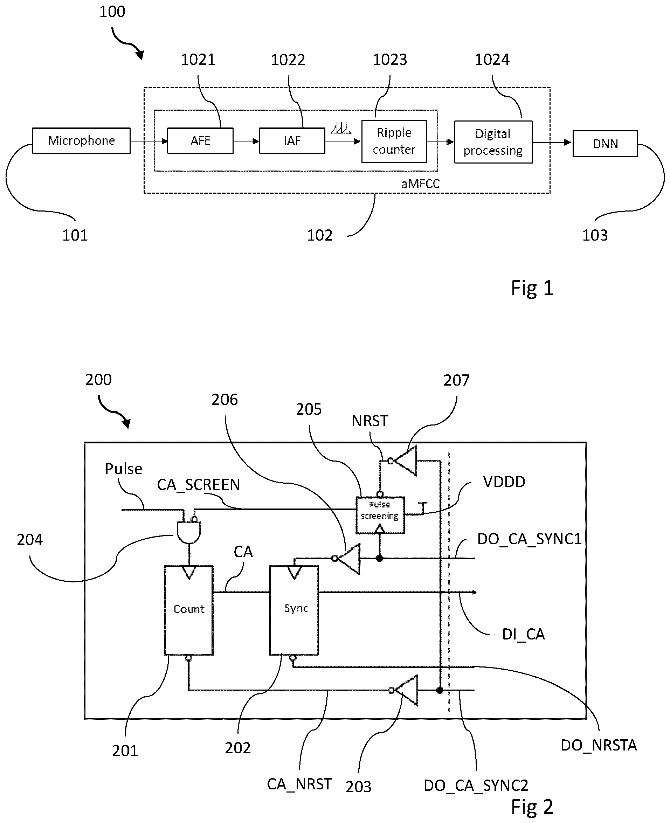

La figure 1 représente, très schématiquement et sous forme de blocs, un mode de réalisation d'un dispositif 100 de traitement d'un fichier audio.

Selon un mode de réalisation, le dispositif 100 est adapté à acquérir un fichier audio, puis à le traiter. Pour cela, et selon un exemple, le dispositif 100 comprend :
- un microphone 101 (Microphone) ;
- un circuit 102 (aMFCC) adapté à la reconnaissance de certaines données audios ; et
- un réseau de neurones 103 (DNN).

Selon un mode de réalisation préféré, le dispositif 100 est adapté à acquérir et à traiter un fichier audio comprenant une voix humaine. Plus particulièrement, le dispositif 100 est adapté à détecter la voix humaine.

Selon un exemple, le microphone 101 est un dispositif électronique adapté à acquérir un fichier audio. Le microphone 101 est configuré pour fournir un fichier audio brut.

Selon un exemple, le circuit 102 est adapté à la reconnaissance de certaines données audios à partir du fichier audio brut fourni par le microphone 101. Selon le mode de réalisation préféré, le circuit 102 est adapté à la reconnaissance de mots.

Selon un exemple, le circuit 102 comprend :
- un circuit 1021 (AFE) adapté à mettre en oeuvre une fonction d'extraction d'une caractéristique acoustique ;
- un circuit 1022 (IAF) adapté à filtrer une caractéristique acoustique extraite par le circuit 1021 ;
- un compteur d'impulsions 1023 (Ripple Counter) selon un mode de réalisation ; et
- un circuit 1024 (Digital processing) configuré pour mettre en oeuvre un traitement numérique d'un signal fourni par ledit compteur d'impulsions 1023.

Selon un exemple, le circuit 1021 (AFE) est adapté à extraire une caractéristique acoustique à partir du fichier audio brut fourni par le microphone 101. Plus particulièrement, le circuit 1021 est adapté à extraire certaines propriétés du fichier audio brut qu'il reçoit de la part du microphone 101.

Selon un exemple, le circuit 1022 (IAF) est adapté à filtrer une caractéristique acoustique extraite par le circuit 1021, et plus particulièrement à intégrer un signal fourni par le circuit 1021. Le circuit 1022 fournit un signal comprenant des impulsions au compteur 1023. Selon un exemple, le circuit 1022 est un convertisseur analogique numérique piloté par un événement logiciel.

Selon un mode de réalisation, le compteur d'impulsions 1023 est un compteur asynchrone fonctionnant dans le domaine analogique du circuit 102, et qui est adapté à compter le nombre d'impulsions du signal fourni par le circuit 1022 pendant une durée donnée. Cette durée donnée correspond généralement à une fenêtre de calcul définie par la durée du fichier audio brut acquis par le microphone 101.

Selon un mode de réalisation, les circuits 1021 et 1022 et le compteur 1023 font tous partie du domaine analogique du circuit 102, et sont tous adaptés à fonctionner à basse fréquence, c'est-à-dire à une fréquence comprise par exemple entre 30 et 40 kHz, par exemple de l'ordre de 32,726 kHz.

Selon un exemple, le circuit 1024 est configuré pour mettre en oeuvre un traitement numérique d'un signal fourni par ledit compteur d'impulsions 1023. Le circuit 1024 fait partie d'un domaine numérique du circuit 102.

Selon un exemple, le réseau de neurones 103 est adapté à recevoir des données de la part du circuit 1024 et à les traiter. Selon un exemple, le réseau de neurones 103 est un réseau de neurones profond.

La figure 2 est un schéma électrique d'un mode de réalisation d'un compteur d'impulsions 200 du type du compteur d'impulsions 1023 décrit en relation avec la figure 1.

Le compteur d'impulsions 200 est un compteur d'impulsions adapté à fonctionner à basse fréquence. Pour cela, le compteur d'impulsions est adapté à compter les impulsions de façon asynchrone, et est adapté à fournir le résultat de son compte de façon synchrone, c'est-à-dire de façon synchronisée sur un signal d'horloge.

Selon un mode de réalisation, le compteur d'impulsions 200 comprend un circuit compteur asynchrone 201 (Count) comprenant une borne d'entrée, une borne de sortie fournissant un signal CA, et une borne de réinitialisation inverseuse recevant un signal de réinitialisation CA_NRST.

Le compteur d'impulsions 200 comprend, en outre et par exemple, une bascule 202 (Sync) permettant la lecture de la valeur du compteur asynchrone 201. La bascule 202 comprend une borne d'entrée recevant le signal CA de la part du compteur asynchrone 201, et une borne de sortie fournissant un signal DI_CA de sortie du compteur d'impulsions 200. Le signal DI_CA représente la valeur du compteur d'impulsions pendant une phase de lecture. La bascule 202 comprend, en outre, une borne d'activation, et une borne de réinitialisation inverseuse recevant un signal de réinitialisation DO_NRSTA.

Le compteur d'impulsions 200 comprend, en outre, un circuit inverseur 203 recevant en entrée un signal de synchronisation DO_CA_SYNC2, et dont la sortie est reliée, de préférence connectée, à la borne de réinitialisation du compteur asynchrone 201. Ainsi, un front montant du signal de synchronisation DO_CA_SYNC2 permet de remettre à une valeur initiale, par exemple à zéro, la valeur du compteur asynchrone 201.

Le compteur d'impulsions 200 comprend, en outre, une porte logique 204 de type "ET" (AND) comprenant une première borne d'entrée recevant un signal Pulse à analyser, et une deuxième borne d'entrée inverseuse recevant un signal CA_SCREEN. Une borne de sortie de la porte 204 est reliée, de préférence connectée, à la borne d'entrée du compteur asynchrone 201.

Selon un mode de réalisation, le compteur d'impulsions 200 comprend, en outre, un circuit 205 (Pulse Screen) configuré pour déclencher une opération de lecture du compteur d'impulsions. Le circuit 205 comprend :
- une borne d'alimentation recevant une tension d'alimentation VDDD ;
- une borne de réinitialisation inverseuse ;
- une borne d'entrée recevant un signal de synchronisation DO_CA_SYNC1 ; et
- une borne de sortie fournissant le signal CA_SCREEN.

Le compteur d'impulsions 200 comprend, en outre, un circuit inverseur 206 recevant en entrée le signal de synchronisation DO_CA_SYNC1, et dont la sortie est reliée, de préférence connectée, à la borne d'entrée de la bascule 202.

Le compteur d'impulsions 200 comprend, en outre, un circuit inverseur 207 recevant en entrée le signal de synchronisation DO_CA_SYNC2, et dont la sortie est reliée, de préférence connectée à la borne de réinitialisation inverseuse du circuit 205.

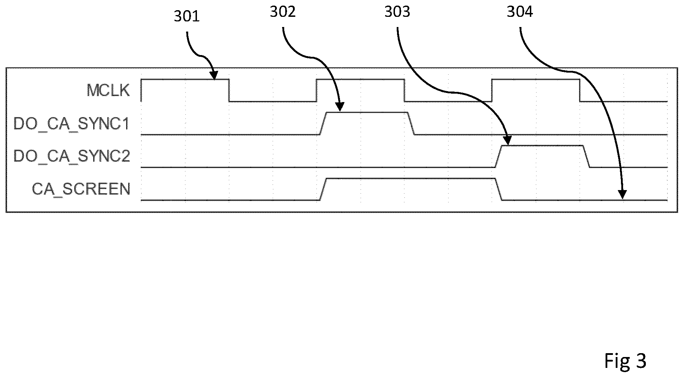

Le fonctionnement du compteur d'impulsions 200 est le suivant. Le compteur asynchrone 201 compte les impulsions présentes sur le signal tant que le signal CA_SCREEN est à un état bas. Une phase de lecture n'a lieu que lorsque le signal CA_SCREEN est à un état haut. La mise en oeuvre d'une phase de lecture de la valeur du compteur asynchrone 201 est décrite en relation avec la figure 3.

La figure 3 comprend quatre chronogrammes 301, 302, 303 et 304 illustrant le fonctionnement du mode de réalisation de la figure 2.

Plus particulièrement, la figure 3 comprend :
- le chronogramme 301 représentant l'évolution temporelle d'un signal d'horloge MCLK ;
- le chronogramme 302 représentant l'évolution temporelle du signal de synchronisation DO_CA_SYNC1 ;
- le chronogramme 303 représentant l'évolution temporelle du signal de synchronisation DO_CA_SYNC2 ; et
- le chronogramme 304 représentant l'évolution temporelle du signal CA_SCREEN.

Le signal d'horloge MCLK permet de synchroniser les phases de lecture de la valeur du compteur asynchrone 201, et les signaux de synchronisation DO_CA_SYNC1 et DO_CA_SYNC2. Selon un exemple, le signal d'horloge est à basse fréquence, c'est-à-dire à une fréquence comprise par exemple entre 30 et 40 kHz, par exemple de l'ordre de 32,726 kHz.

Comme dit précédemment, une phase de lecture est mise en oeuvre lorsque le signal CA_SCREEN est à un état haut.

Un front montant du signal CA_SCREEN est déclenché par un front montant du signal de synchronisation DO_CA_SYNC1, qui est lui-même déclenché à un front montant du signal d'horloge MCLK.

De plus, un front montant du signal de synchronisation DO_CA_SYNC1 permet de désactiver la bascule 202, et donc de fixer la donnée qu'elle stocke. Cette donnée correspond à la valeur du compteur asynchrone 201. Un front descendant du signal de synchronisation DO_CA_SYNC1 est déclenché par un front descendant du signal d'horloge MCLK. Le front descendant du signal de synchronisation déclenche la lecture de la valeur du compteur asynchrone 201.

Un front descendant du signal CA_SCREEN est déclenché par un front montant du signal de synchronisation DO_CA_SYNC2. Ce front montant du signal de synchronisation DO_CA_SYNC2 permet, en outre, de réinitialiser le compteur asynchrone 201.

Un avantage de ce mode de réalisation d'un compteur d'impulsions est qu'il peut être mis en oeuvre par un circuit fonctionnant à basse fréquence, même si la fréquence des impulsions reçues est supérieure à cette basse fréquence. En particulier, ce compteur d'impulsions peut être intégré à une partie d'un dispositif électronique consommant peu d'énergie et étant toujours allumé, couramment appelée partie ALWAYS ON.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Compteur d'impulsions (1021 ; 200) comprenant un compteur asynchrone (201) et un circuit (205) configuré pour déclencher une opération de lecture de la valeur dudit compteur asynchrone, ledit circuit (205) étant synchronisé par un signal d'horloge.

2. Compteur selon la revendication 1, comprenant, en outre, une bascule (202) adaptée à recevoir ladite valeur dudit compteur asynchrone (201) pendant une phase de lecture.

3. Compteur selon la revendication 1 ou 2, dans lequel une phase de lecture est déclenchée par un front d'un premier signal de synchronisation (DO_CA_SYNC1).

4. Compteur selon l'une quelconque des revendications 1 à 3, dans lequel une phase de lecture est arrêtée par un front d'un deuxième signal de synchronisation (DO_CA_SYNC2) .

5. Compteur selon la revendication 4, dans lequel ledit front du deuxième signal de synchronisation (DO_CA_SYNC2) déclenche, en outre, la réinitialisation de ladite valeur dudit compteur asynchrone (201).

6. Circuit (102) adapté à la reconnaissance de mots à partir d'un fichier audio comprenant un compteur d'impulsions (1023 ; 200) selon l'une quelconque des revendications 1 à 5.

7. Circuit selon la revendication 6, ayant une fréquence d'horloge comprise entre 30 et 40 kHz.

8. Circuit selon la revendication 7, dans lequel la fréquence d'horloge est égale à 32,728 kHz.

9. Circuit selon l'une quelconque des revendications 6 à 8, comprenant, en outre, un premier circuit (1021) adapté à mettre en oeuvre une fonction d'extraction d'une caractéristique acoustique.

10. Circuit selon l'une quelconque des revendications 6 à 9, comprenant, en outre, un deuxième circuit (1022) adapté à intégrer un signal fourni par le premier circuit (1021).

11. Circuit selon l'une quelconque des revendications 6 à 10, comprenant, en outre, un troisième circuit (1024) configuré pour mettre en oeuvre un traitement numérique d'un signal fourni par ledit compteur d'impulsions (1021 ; 200) .

12. Dispositif (100) adapté à traiter un fichier audio comprenant un circuit (102) selon l'une quelconque des revendications 6 à 11.

13. Dispositif selon la revendication 12, comprenant en outre un microphone (101).

14. Dispositif selon la revendication 12 ou 13, comprenant en outre un réseau de neurones (103).

15. Dispositif selon l'une quelconque des revendications 12 à 14, adapté à détecter la voix humaine.
